# EUROPEAN PATENT APPLICATION

(11) **EP 1 345 033 A1**
(43) Date of publication of application: **17.09.2003**
(21) Application number: 03380023.6
(22) Date of filing: 07.02.2003
(51) Int. Cl.: G01R 15/14

(54) **Electrical transformer for voltage and current measurement based on the electromagnetic waves sensored in dielectric**

(30) Priority: 15.02.2002 ES 200200374
(71) Applicant: Esdras Automatica, 28230 Las Rozas de Madrid (ES)
(72) Inventor: Talavera Martin, Juan A., 28230 Las Rozas de Madrid (ES)

(57) **Abstract**

Electrical transformer for voltage and current measurement based on the electromagnetic waves reception in dielectric and formed by a general structure with three subsystems: the primary circuit (P), the sensor subsystem (S) and the conversion unit (C). The sensor subsystem is constituted by field concentrators (2) and receivers (4), embedded in dielectric material (3), that generate electrical signals in a constant and determined relation with the variable electric and magnetic field magnitudes. In the converter unit (6) the signals by the receivers are amplified, converted to digital format, compensated, calibrated and transmitted. The major application fields of this transformer is in the generation, transmission and distribution of electrical energy.

## Description

### OBJECTO OF THE INVENTION

The following report describes a patent for an invention involving transformer for voltage and current measurement in alternating-current (ac) electrical circuits on the basis of electromagnetic waves propagation in dielectric medium and its detection. The device consists of a sensor subsystem that detects the variations of the electric and magnetic fields in dielectric medium and circuits for amplification, compensation, calibration and conversion of the generated signals representing the voltage and current from the primary circuit.

### FIELD OF APPLICATION

These transformers can be used for voltage and current metering as well as protection in power electrical circuits where the current or the voltage is high enough to avoid the direct introduction of these magnitudes into the measurement equipment. Although they can be used in a broad range of frequencies, their major field of application is within the generation, transmission and distribution of electrical energy at high voltage and current with frequencies, usually, of 50 and 60 Hz. Also, they are used in all circuits, including those with low voltage, when it is required galvanic insulation of the secondary from the primary circuit.

### HISTORY

The transformers of voltage and current are devices for amplitude change of these electrical magnitudes. This change is produced by means of the generation of an alternative magnetic flux with the primary circuit that reaches the secondary circuit through a ferromagnetic core and induces variations of voltage and current opposing the variations of magnetic flux.. The ratio between the numbers of turns of the primary and secondary circuits determines the ratio of the primary and secondary voltage and current amplitudes. When these devices are used as intermediate elements for the current and voltage measurement, besides the change of amplitudes, it is very impouant the insulation that they provide due to the fact that the primary and secondary circuits are linked through the magnetic flux without any direct electrical contact.

This last feature made the transformers particularly useful for the electrical power grids where the voltage of the primary circuits is very high and require an important galvanic insulation. However, at the same time as voltage and current to be measured increase due to the increment of power of the electrical grid, there is a linear increase in the number of turns and in the insulation of the turns with respect to the ground. This means that the size, which is the result of the product of both factors, increases exponentially and producing devices extremely large and disproportionately expensive, considering the power of the signals they are meant to handle. It is not surprising that there has been a great deal of recent interest in the development of new alternatives in this particular field.
During the last few decades a number of devices have been proposed. Undoubtedly, the most promising current line of investigation is centered in the area of fiber optics, both active and passive. As the fiber optics are made of dielectric materials which can transmit light energy but not electrons, they make highly efficient galvanic separation of the circuits possible.

### DESCRIPTION OF THE INVENTION

In the measurement of voltage and current transformers proposed, the energy is transmitted through the dielectric medium in the same way that the electromagnetic waves propagate in the air. A well known phenomena and theoretically explained by the Maxwell equations.
However, it presents the problem of the reduced propagated energy in frequencies so extremely low as the 50 and 60 Hz of the electric power distribution grids. Moreover, other sources of electromagnetic emission very close, just as are the conductors of the other phases, may introduce excessive noise in the measurements. To get surpass these problems, the proposed instrument transformers are constituted with the following more significant elements:
a) Conductor of the primary circuit (P). The conductor is at the electric voltage and circulates through it the electric current that it is wanted to be measured.
b) Sensor subsystem (s) formed with the following more significant elements:
   B1 ) concentrator of magnetic and electric fields. Structures that they try to increase the magnitude of the electric and magnetic fields from the conductor of the primary circuit. The concentrators of electric fields are of two types: 1 ) internal primary circuit and 2 ) external primary circuit. In the first type a conducting material connected to the primary circuit surrounds the receiver. In the second type, a conducting covering connected to the earth potential roundabout the primary circuit. Due to the proximity of the conducting surfaces and to its different potentials, then electric fields are very intense. For other side, the concentrator of magnetic field are of two types: 1) circuit with low magnetic reluctance and 2 ) external components null. Both types try to maximize the ratio between the primary circuit armature magnetic field and the external currents armature magnetic fields. In the first type is achieved through ferromagnetic material while in the second by means of a close surface that concatenates, without crossing; the primary circuit.
   B2 ) dielectric medium where they are immersed the receivers. This medium, which supports very high electric fields, may be of gaseous, liquid or solid insulating materials and even the vacuum.
   B3 ) receivers of electric and magnetic fields. Surrounded by dielectric material, the receivers sense the variations and they generate proportional electric signals to the magnitude of the electric and magnetic fields. To reduce dimensions, both receivers are able to be integrated in a receiving nucleus. This nucleus is constituted by a conducting covering that is connected to a high impedance amplifier and, to reduce the voltage without changing the phase, to a capacitor. In the covering are generated the voltage signals due to the variations of the electric field where the receiver is immersed. To augment the signal to noise ratio of the receiver can be added seconds separated conducting covering. This realization permits use a differential amplifier with its two inputs connected to every one of the covering. In the inside, or outside depending of the type of concentrator, of the covering, or coverings, and insulated from them, is placed a coil whose two terminals are led also to an electronic amplification circuit. The voltage and electric current generated in the coil are proportional to the variations in time of the magnetic field.
c) Converter unit (c). In this unit are amplified, compensated and calibrated the signals from the sensor subsystem. The signals can be converted to digital format to be processed or transmitted, through serial line or bus to the equipment that use them. The transmission can be carried out by means of internal bus to units of a same system or by means of communication line under different protocols, just as the IEC61850-9 family, to link with external systems. In other variant, in which it is aimed compatibility with conventional equipments, the signals receive a power amplification and they are passed to the ranges of the conventional instrument transformers; for example, 110 V for the voltage measurement and 5A/1A for the electric current measurement.

### DESCRIPTION OF THE DRAWINGS

To complement the description and aiming to help to understand better the characteristics of the invention, accompanies to this memory as integral part it, two graphic pages in which, with illustrative and not limitative character, it has been represented the following:

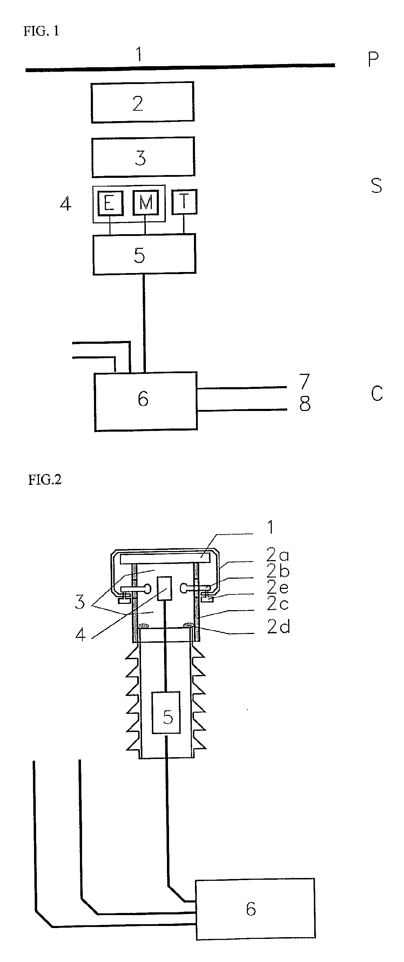

The figure 1 shows the block diagram of a transformer for voltage and electric current measurement based on electromagnetic wave reception in dielectric medium with the primary circuit (1), the concentrators of magnetic and electric fields ( 2 ), the dielectric medium ( 3 ), the receivers ( 4 )- are represented the receiver of electric field ( E), magnetic field (M) and temperature (T), the conditioning circuits ( 5 ) and finally the conversion unit ( 6 ) that sent the signal in digital format ( 7 ) or in the classic ranges of, for example, 110V/5A-1A ( 8 ).

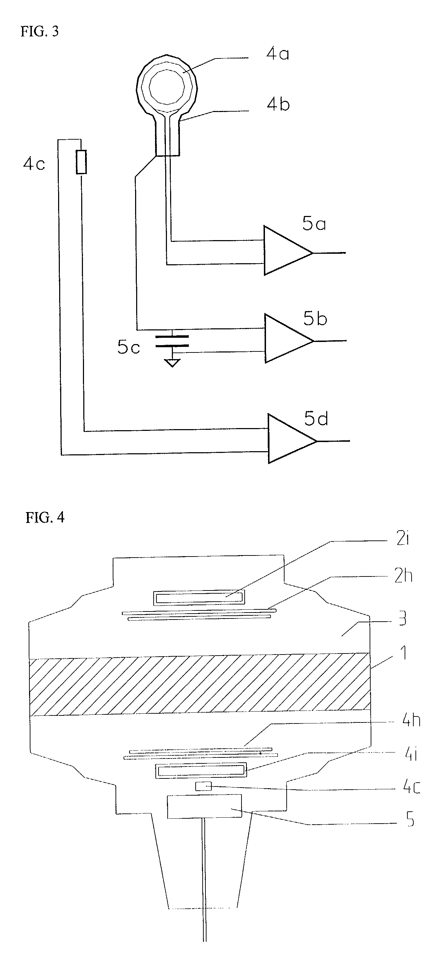

The figure 2 shows a front view, cross section, of a realization form of a transformer for voltage and electrical current measurement based on electromagnetic waves with the primary circuit (1), the concentrators of magnetic and electric fields ( 2 ) surrounding the primary conductor (2a), projecting the magnetic field (2b), concatenating the electric field (2c), completing the screening of the receivers (2d) and subduing under pressure the whole by means of screws (2e). The dielectric medium ( 3 ), the receivers ( 4 ), conditioning circuits ( 5 ) and finally the conversion unit ( 6 ) complete the figure.
The figure 3 shows, in schematic form, the nucleus with the receivers of electric and magnetic fields, as well as, their amplifiers of the voltage and electrical current instrument transformer. The nucleus, in the case of having integrated the receivers, is composed of a coil (4a) surrounded, but without electric contact, by a conducting covering (4b). The conducting covering connects to a high impedance amplifier (5b) with a capacitor (5c) in parallel. While the coil connects to other amplifier in differential mode by means of two terminals (5a). Finally, appears in the figure, a temperature sensing element (4c) with its corresponding amplifier (5d).
The figure 4 shows, on schematic form, a cross section front view of other realization with primary circuit ( 1 ) surrounded by a conducting covering (2h) with the voltage sensor (4h) in the intermediate region and the magnetic field sensor (4i) surrounded externally. The dielectric material ( 3) separates and covers all the previous structures.

### PREFERRED FORMS OF THE INVENTION

In the figure 1 is represented the bloc diagram of a realization of the transformer that simultaneously measures the electric field, the magnetic field and the temperature. In this figure are the three subsystems of the transformer: primary circuit ( P); sensor (S) and conversion unit (C). The primary circuit (P) is basically made by the high voltage conductor (1). The sensor (S) is constituted by the concentrators of magnetic and electric fields ( 2 ). A dielectric medium ( 3 ) separates the primary circuit and concentrators of the receivers ( 4 ) of electric field (E), magnetic field (M) and, optional, temperature (T), as well as, also optional, the conditioning circuits ( 5 ) of the signals of the receivers. This conditioning circuits is part of the conversion unit that separates from it and integrates into the receiver to improve the signal to noise ratio. Thus, these circuits ( 5 ) are able to have the amplification, compensation, filtering and calibration functions, as well as, conversion to digital format. The unit of conversion (C) is formed by the amplification, filtering, compensation, calibration and conversion circuits ( 6 ) that they send the signals, in a variant, in digital format ( 7 ) or, according to the other variant ( 8 ), in the conventional ranges ( for example, 110V/ 5-1A), to the metering and protection equipments.

The cross section of a combined transformer realization is represented in figure 2 where appears the conductor of the primary circuit like a rigid sheet metal (1) that goes through the covering ferromagnetic concentration structures of the magnetic field (2a). The magnetic field is internally focused by means of ferromagnetic prolongations (2b) towards the receivers (4). The prolongations (2b) are able to even go through the receivers (4) constituting the core of the coil of the magnetic field receiver. On the other hand, the conducting covering (2c) serves to concentrate the electric field on its receiver, as well as, screening from external fields along with the lower ring (2d) and all the upper external covering (2a). By means of screws (2e) the whole structure is under pressure and remains hanging of the primary circuit conductor. The dielectric medium ( 3 ) insulates all this component conductors that are at high voltage from the receivers (4) and the conditioning circuits ( 5 ). The signals are conducted finally to the conversion unit ( 6 ) that is distant of the primary circuit. The conversion unit ( 6 ) is able to receive also the signals of other sensors that measure the magnitudes in other phases or points of the circuit. In the figure 2 it has represented receiving the signals from three sensors.

It is shown schematic of the receivers of electric and magnetic fields of this realization ( figures 3 ) which are composed of a coil (4a) surrounded, but without electric contact, by a conducting covering (4b) that connects to a high impedance amplifier (5b) with a capacitor (5c) in parallel. This receiving circuit is capable of generating a proportional signal from variations of the electric field. On the other hand, the coil connects to other amplifier in differential mode by means of two terminal (5a) constituting the receiver of the variations of the magnetic field. This realization includes a temperature sensing element (4c) with its corresponding amplifier (5d) for compensation of the temperature drifts of the receiver circuits. These amplifiers and components ( 5a, 5b, 5c, 5d ) are of the conditioning circuits ( 5 ) pertaining to the conversion unit ( 6 ). They are able to be integrated in the unit ( 6 ) or near the receivers to improve the signal to noise ratio.

The figure 4 represents a realization where the concentrator of electric field is constituted for an internal primary circuit (1) surrounded by a conducting covering (2h) connected to the potential of earth. In the intermediate region, next to the covering (2h) is placed the receiver of electric field (4h) based, also, on a concentric covering. In other realization, the receiver of electric field is constituted by two concentric covering separated with a thin dielectric. This last realization a differential amplifier connected to each of the two receiver covering may be used. The concentrator of magnetic field, of the type of null external component, is a ring (2i) that surrounds the previous structures and permits be winding all its circumference. Thus, the winding of the receiver of magnetic field (4i) forms a complete toroid coil that encircle the primary circuit and the receiver of voltage. Optionally, in other realizations, it can include a sensitive element to the temperature (4c) that permits to improve the precision and the security. Connections to the primary circuit by means of standard separable connectors, in this realizations, facilitates the incorporation of the sensor in installations of reduced space such as the gas insulated. In this way, the sensor is intercalated in high and middle voltage circuit by means of two standard separable connectors. Also is able to function as bushing with separable connection.

Other set of realizations is based on different variants of the voltage sensor. Thus, the voltage sensor can be substituted by the screen of the high voltage cables and then connect it to earth by means of a capacitor. Other realization is the substitution of the sensor by a high voltage capacitor connected to the primary circuit. Finally, there are possibilities that voltage sensor is formed by the winding or the core of the current sensor if it is made of conducting material. In these last two realizations the potential of the current sensor is floating and it is measured in common mode.

The unit of conversion (c), whose block ( 6 ) is represented in the figure 2, modifies the magnitude and optionally samples the signals to be digitally processed. Moreover, it can include the calibration, as well as, compensation functions in order to achieve higher precision. The principal compensation functions are: the temperature drifts, the linearity and, if required, the phase. This last compensation is needed, besides the usual delays that introduce the circuits, because the voltage signal phase from the magnetic field receiver is 90 degrees in advance than the primary circuit current.

The terms used in this report are not meant to limit their wider interpretation. The materials, forms and dispositions of the elements can be changes as long as the essence of the invention is not altered.

## Claims

1. Transformer for voltage and current measurement in the generation, transmission and distribution circuits of alternating electric power based on the reception of electromagnetic waves in dielectric medium by means of a general structure constituted with three subsystems: the primary circuit (P), the sensor subsystem for the electric and magnetic fields (S) and the conversion unit (C).

2. Transformer for voltage and current measurement, according to the first claim, with the sensor subsystem constituted by concentrators of magnetic and electric fields (2).

3. Transformer for voltage and current measurement, according to the first claim, with sensor subsystem constituted by receivers of electric and magnetic fields ( 4 ) immersed in dielectric medium ( 3 ).

4. Transformer for voltage and current measurement, according to the first claim, having receivers of electric and magnetic fields integrated in a nucleus, according to one of the realization forms, constituted by a conducting external covering (4b) that is connected to a high impedance electronic amplifier (5b) in parallel with a capacitor (5c) for the reception of electric field variations. In the inside of the covering, and insulated from it, is placed a coil (4a) whose two terminals also are led to other electronic circuit (5a) for the reception of the magnetic field variations.

5. Transformer for voltage and current measurement, according to the first claim, having a conducting covering (2c), connected to the primary circuit, that surround the receivers ( 4) and a ring of ferromagnetic material ( 2a, 2b ) that circles the primary circuit and is able to go through the magnetic field receiver.

6. Transformer for voltage and current measurement, according to the first claim, having a electric field receiver forms by a conducting covering (4h) that surrounds, insulated by the dielectric material ( 3 ), the primary circuit (1). This receiver can be surrounded by other conducting covering (2h) connected to the earth potential.

7. Transformer for voltage and current measurement, according to the first claim, having a magnetic field receiver made up of a coil (4i) of uniform winding toroid form over a complete ring of non-ferromagnetic material, included the vacuum or the air, or ferromagnetic material that surrounds the primary circuit and the structure for electrical field measurement.

8. Transformer for voltage and current measurement, according to the first claim, distinguished by forming the electric field receiver with the high voltage cable screen.

9. Transformer for voltage and current measurement, according to the first claim, distinguished by the electric field receiver formed with two conducting coverings, surrounding the primary circuit, properly insulated and connected to a differential amplifier inputs.

10. Transformer for voltage and current measurement, according to the first claim, distinguished by having the electric field receiver formed with the winding of the magnetic field receiver.

11. Transformer for voltage and current measurement, according to the first claim, having the electric field receiver made up with the core of the magnetic field receiver.

12. Transformer for voltage and current measurement, according to the first claim, having electric and magnetic fields receivers that can be accompanied by a temperature sensor (4c) that is connected to an electronic amplification circuit (5d).

13. Transformer for voltage and current measurement, according to the first claim, distinguished by permitting the connection by means of standard separable connectors of power cables to both sides of the primary circuit.

14. Transformer for voltage and current measurement, according to the first claim, distinguished by being used as bushing.

15. Transformer for voltage and current measurement, according to the first claim, having a conversion unit ( 6 ) in which the signals from the sensor subsystem are amplified, filtered, compensated, calibrated, converted to digital format and transmitted. This unit is able to receive and to process the signals of several sensor subsystems.

16. Transformer for voltage and current measurement, according to the first claim, having conversion unit ( 6 ) connected to the sensor subsystems by means of multipolar signal cables and connectors of RJ11, RJ45 type or similar.

17. Transformer for voltage and current measurement, according to the first claim, distinguished for having a conversion unit ( 6 ) where the signals can receive power amplification and the outputs have the same voltage and current ranges that have the secondary circuits of conventional instrument transformers.
